(19) Europäisches Patentamt
European Patent Office
Office européen des brevets

(11) **EP 2 586 090 B1**

(12) **EUROPÄISCHE PATENTSCHRIFT**

(45) Veröffentlichungstag und Bekanntmachung des Hinweises auf die Patenterteilung:
**10.08.2022  Patentblatt 2022/32**

(21) Anmeldenummer: **11718741.9**

(22) Anmeldetag: **10.05.2011**

(51) Internationale Patentklassifikation (IPC):
***H01M 10/48*** *(2006.01)*

(52) Gemeinsame Patentklassifikation (CPC):
**G01R 31/396; B60L 58/10; H01M 10/482;**
B60L 58/21; G01R 31/367; G01R 31/392;
Y02E 60/10; Y02T 10/70

(86) Internationale Anmeldenummer:
**PCT/EP2011/057529**

(87) Internationale Veröffentlichungsnummer:
**WO 2011/160890 (29.12.2011 Gazette 2011/52)**

(54) **VERFAHREN ZUR FESTSTELLUNG WENIGSTENS EINES ZUSTANDES EINER MEHRZAHL VON BATTERIEZELLEN, COMPUTERPROGRAMM, BATTERIE UND KRAFTFAHRZEUG**

METHOD FOR DETERMINING AT LEAST ONE STATE OF A PLURALITY OF BATTERY CELLS, COMPUTER PROGRAM, BATTERY AND MOTOR VEHICLE

PROCÉDÉ PERMETTANT D'ÉTABLIR AU MOINS UN ÉTAT D'UNE PLURALITÉ D'ÉLÉMENTS DE BATTERIE, PROGRAMME INFORMATIQUE, BATTERIE ET VÉHICULE AUTOMOBILE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **24.06.2010  DE 102010030491**

(43) Veröffentlichungstag der Anmeldung:
**01.05.2013  Patentblatt 2013/18**

(73) Patentinhaber:
• **Samsung SDI Co., Ltd.**
  **Gyeonggi-do (KR)**
• **Robert Bosch GmbH**
  **70442 Stuttgart (DE)**

(72) Erfinder:
• **BOEHM, Andre**
  **70806 Kornwestheim (DE)**
• **WICKERT, Stefan**
  **73095 Albershausen (DE)**

(74) Vertreter: **Bee, Joachim et al**
  **Robert Bosch GmbH**
  **Zentralabteilung Patente**
  **Postfach 30 02 20**
  **70442 Stuttgart (DE)**

(56) Entgegenhaltungen:
**EP-A2- 1 328 052**        **EP-A2- 2 159 585**
**US-A1- 2007 222 418**        **US-A1- 2008 233 471**

• **"IEEE Standard for Rechargeable Batteries for Multi-Cell Mobile Computing Devices;IEEE Std 1625-2008 (Revision of IEEE Std 1625-2004)", IEEE STANDARD, IEEE, PISCATAWAY, NJ, USA, 20. Oktober 2008 (2008-10-20), Seiten C1-79, XP017602048, ISBN: 978-0-7381-5800-6**

**Beschreibung**

Die vorliegende Erfindung betrifft ein Verfahren zur Feststellung eines Ladezustandes und / oder eines Alterungszustands einer Mehrzahl von räumlich zusammengefassten und schaltungstechnisch miteinander verbundenen Batteriezellen.

Des Weiteren betrifft die vorliegende Erfindung ein Computerprogramm, mit dem das erfindungsgemäße Verfahren realisierbar ist, sowie eine Batterie mit wenigstens einem Batteriemanagementsystem, wobei das Batteriemanagementsystem derart ausgebildet ist, dass mit ihm das erfindungsgemäße Verfahren realisierbar ist. Außerdem betrifft die Erfindung ein Kraftfahrzeug mit einer erfindungsgemäßen Batterie.

Eine Batterie, die eine oder mehrere galvanische Batteriezellen umfasst, dient als elektrochemischer Energiespeicher und Energiewandler. Bei der Entladung der Batterie bzw. der jeweiligen Batteriezelle wird in der Batterie gespeicherte chemische Energie durch eine elektrochemische Redoxreaktion in elektrische Energie umgewandelt. Diese elektrische Energie kann somit je nach Bedarf von einem Nutzer angefordert werden.

Insbesondere in Hybrid- und Elektrofahrzeugen werden in so genannten Batteriepacks Lithium-Ionen-Batterien oder Nickel-Metallhydrid-Batterien eingesetzt, die aus einer großen Anzahl in Serie geschalteter elektrochemischer Zellen bestehen. Üblicherweise dient ein Batteriemanagementsystem inklusive einer Batteriezustandserkennung zur Sicherheitsüberwachung und zur Gewährleistung einer möglichst hohen Lebensdauer.

Stand der Technik

Aus der DE 199 59 019 A1 ist ein Verfahren zur Zustandserkennung eines Energiespeichers bekannt, mittels dessen unter Verwendung eines Modells, eines Filters und eines Parameterschätzers eine genaue und zuverlässige Energiespeicherdiagnose durchführbar ist. Durch die Parameterschätzung ist es möglich, auf Grund der Alterung des Energiespeichers oder auf Grund von Defekten sich einstellende Modellparameter festzustellen und das Modell, auf dem die Schätzungen im Wesentlichen beruhen, ständig dem Istzustand anzugleichen und nachzuführen.

Die Druckschrift "IEEE Standard for Rechargeable Batteries for Multi-Cell Mobile Computing Devices; IEEE Std 1625-2008 (Revision of IEEE Std 1625-2004)", IEEE STANDARD, IEEE, PISCATAWAY, NJ, USA, 20. Oktober 2008 (2008-10-20), Seiten C1-79, offenbart ein Verfahren zur Feststellung unterschiedlicher Zustände einer Mehrzahl von Batteriezellen, wobei als Beobachterstruktur eine Testvorschrift zum Einsatz kommt, die eine Teilmenge einer Gesamtheit von Batteriezellen beobachtet und daraus den Zustand für weitere Batteriezellen, die nicht beobachtet werden, feststellt.

Die Druckschrift EP 2 159 585 A2 offenbart eine Batterie in einem Kraftfahrzeug, die mehrere räumlich zusammengefasste und schaltungstechnisch miteinander verbundene Batteriezellen sowie mehrere Batteriemanagementsysteme umfasst und mit einem Antriebssystem eines Kraftfahrzeugs verbindbar ist.

Die Druckschrift US 2008 / 0233471 A1 offenbart eine konventionelle Vorrichtung zur Erkennung des Zustandes eines Energie- oder Ladungsspeichers.

Zwecks Sicherheitsüberwachung und zur Gewährleistung einer möglichst hohen Lebensdauer ist es außerdem bekannt, die Spannung jeder einzelnen Zelle zusammen mit dem Batteriestrom und der Batterietemperatur zu messen und eine Zustandsschätzung hinsichtlich des Ladezustandes und/oder des Alterungszustandes vorzunehmen.

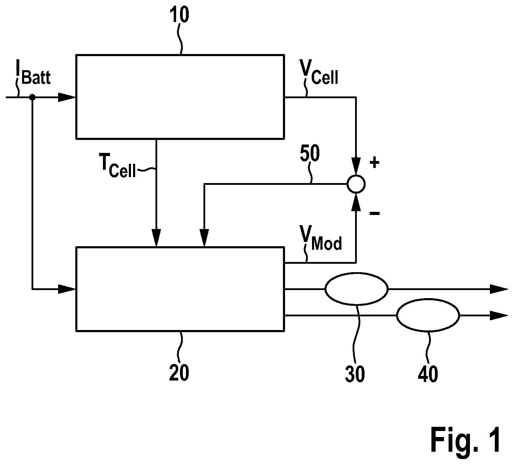

In technisch hochwertigen Batteriemanagementsystemen werden regelungstechnische Beobachterstrukturen eingesetzt. Eine solche Beobachterstruktur ist beispielhaft in Figur 1 dargestellt.

Unter einem Beobachter wird ein System verstanden, das mittels eines Modells und unter Verwendung von bekannten feststehenden Eingangsgrößen und/oder Messgrößen Zustände feststellt bzw. ableitet. Derartige Zustände sind üblicherweise in ihrer Größe auf Grund ihrer Komplexität nicht oder nur mit sehr großem Aufwand messbar.

Der Beobachter bildet in dem Modell somit eine tatsächliche Regelungsstrecke bzw. ein reales System nach. Er kann einen Regler umfassen, der die messbaren Zustandsgrößen nachführt. Ein bekannter Beobachter ist der so genannte Luenberger-Beobachter.

Durch den Einsatz eines Beobachters bzw. einer Beobachterstruktur, wie in Figur 1 dargestellt, lassen sich die Zustände Lebensdauer und Leistungsfähigkeit eines Batteriepacks jederzeit präzise bestimmen. Die dabei verwendeten Zellenmodelle entsprechen theoretischen Abbildungen bzw. mathematischen Modellen. Sie verfügen über zahlreiche Parameter zur Beschreibung der Kapazität und der Impedanz der Einzelzelle. Aus diesen Parametern werden Energieinhalte und Leistungsfähigkeit der Zellen und des gesamten Packs, sowie Lebensdauerprognosen errechnet. Diese Werte können ebenfalls Parameter der Zellmodells bzw. der Beobachterstruktur sein.

Die Parameter ihrerseits haben sehr häufig mehrdimensionale Abhängigkeiten von Zustandsgrößen wie zum Beispiel Temperatur, Ladezustand, Stromstärke und ähnlichen Größen. Es ergeben sich daher komplexe Parameterräume, in denen die Parameter zu beobachten sind. Jeder Zelle ist ein dedizierter Beobachter zugeordnet.

Zwecks Korrektur eines jeden Zellmodells ist ständig ein Abgleich zwischen dem Zellmodell und der jeweiligen Zelle mit den tatsächlich an oder in der betreffenden Batteriezelle herrschenden Bedingungen bzw. deren Größen wie zum Beispiel Temperatur durchzuführen.

Eine herkömmliche Beobachterstruktur 20 ist, wie in Figur 1 dargestellt, parallel zu einer Batteriezelle 10 angeordnet. Der Wert eines durch die Batteriezelle 10 fließenden Stromes $I_{Bat}$ wird als Information der Beobachterstruktur 20 zugeleitet. Ebenso wird der Wert einer an oder in der Batteriezelle 10 gemessenen Temperatur der Zelle $T_{Cell}$ der Beobachterstruktur 20 zugeleitet. Die an der Batteriezelle 10 gemessene Spannung $V_{Cell}$ wird mit der im Zellenmodell der Beobachterstruktur 20 ermittelten Modellspannung $V_{Mod}$ verglichen und der Wert der daraus resultierenden Differenzspannung 50 der Beobachterstruktur 20 wieder zugeführt. Von der Beobachterstruktur 20 werden die Zustände der Ladung 30 sowie der Alterung 40 geschätzt.

Die dargestellte Beobachterstruktur 20 ist dabei nicht auf die Feststellung des Ladungszustandes 30 und des Alterungszustandes 40 alleine eingeschränkt, sondern es sind je nach Bedarf und in Abhängigkeit von der Berechnungskapazität auch weitere Zustände ermittelbar. Ebenso ist die Beobachterstruktur 20 nicht auf die Eingabe der Werte der Stromstärke, Temperatur und Spannung eingeschränkt.

Bei der Anwendung der Beobachterstruktur zur Erfassung von Zuständen von Batteriezellen wird jede einzelne Zelle mit Hilfe des Zellenmodells und der regelungstechnischen Beobachterstruktur nicht nur in ihrem Ladezustand, sondern auch in alterungsspezifischen Parametern wie dem so genannten "State of Health" (SOH, "Alterungszustand") nachgeführt.

Nachteilig ist dabei, dass dieser Vorgang mit einem enormen Rechenaufwand und Speicherbedarf verbunden ist, der zudem mit der Anzahl der Zellen proportional steigt. Dies ist ungünstig im Hinblick auf die von der Automobilindustrie üblicherweise gewünschte Skalierbarkeit von Batterie-Plattformsystemen, die in der zur Aufwands- und Kostenreduktion in der Herstellung von Batteriesystemen unterschiedlicher Leistung essentiell sind, und die dadurch erforderliche Rechenleistung.

Offenbarung der Erfindung

Es wird erfindungsgemäß ein Verfahren zur Feststellung eines Ladezustands und/oder eines Alterungszustands einer Mehrzahl von räumlich zu einem Batteriepack zusammengefassten und schaltungstechnisch miteinander verbundenen Batteriezellen, wobei die Feststellung des Ladezustands und/oder des Alterungszustands durch Beobachtung von Batteriezellen mittels wenigstens einer Beobachterstruktur realisiert wird, dadurch gekennzeichnet, dass die Gesamtheit aller Batteriezellen in Gruppen unterteilt ist, wobei einer Gruppe jeweils eine Teilmenge von Batteriezellen zugeordnet ist, wobei die Teilmenge der Gesamtheit von Batteriezellen beobachtet wird und die Beobachtung alternierend gruppenweise erfolgt und weiterhin der aus der Beobachtung abgeleitete Ladezustand und/oder Alterungszustand für mehr Batteriezellen als für die beobachteten Batteriezellen festgestellt wird, wobei für wenigstens einen Parameter analysiert wird, wie groß die Streuung des Parameters der Gesamtheit der Batteriezellen ist, wobei im Fall, dass die Streuung einen vorher festgesetzten Grenzwert nicht überschreitet, eine mittlere Änderung des Parameters für die Feststellung des jeweiligen Ladezustands und/oder Alterungszustands aller Batteriezellen der Gesamtheit der Batteriezellen verwendet wird.

Das Modell des Beobachters ist hier ein Zellenmodell, welches ein mathematisches Abbild einer die tatsächliche Regelungsstrecke darstellenden Batteriezelle ist.

Vorteile der Erfindung

Durch die Beobachtung lediglich einer Teilmenge $n_x$ der Gesamtheit der Batteriezellen $n_{ges}$ lässt sich der Rechenaufwand und Speicherbedarf des Batteriemanagementsystems wesentlich reduzieren.

In einer Ausgestaltung des erfindungsgemäßen Verfahrens erfolgt die Feststellung des Ladezustandes und / oder des ALterungszustandes mittels Schätzung. Alternativ kann auch eine Berechnung vorgenommen werden. Das heißt, dass die Beobachterstruktur den Zustand oder die Zustände schätzt oder berechnet.

Das erfindungsgemäße Verfahren zur Feststellung eines Ladezustandes und / oder eines Alterungszustands einer Mehrzahl von räumlich zusammengefassten und schaltungstechnisch miteinander verbundenen Batteriezellen kann insbesondere derart ausgestaltet sein, dass der jeweilige Zustand für die beobachteten Batteriezellen sowie auch für nicht beobachtete Batteriezellen festgestellt wird.

Vorzugsweise wird der Zustand für alle Batteriezellen des jeweiligen Packs festgestellt, das heißt für die Batteriezellen, die räumlich und schaltungstechnisch miteinander verbunden sind.

Wenigstens ein feststellbarer Zustand ist der Ladezustand oder der Alterungszustand. Vorzugsweise ist das erfindungsgemäße Verfahren derart ausgestaltet, dass beide Zustände an einer oder mehreren Batteriezellen feststellbar sind.

In besonders vorteilhafter Ausführung des erfindungsgemäßen Verfahrens ist vorgesehen, dass die Gesamtheit aller Batteriezellen $n_{ges}$ in Gruppen unterteilt ist, wobei einer Gruppe jeweils eine Teilmenge $n_i$ von Batteriezellen zugeordnet ist, und wobei die Beobachtung alternierend gruppenweise erfolgt. Das heißt, dass die Zustände der Gruppen von Batteriezellen nacheinander festgestellt werden. Es bietet sich dabei der Ablauf des Verfahrens in einer Schleife an. Diese alternierende Beobachtung einer reduzierten Anzahl von Zellen anstatt der gleichzeitigen Überwachung aller Zellen ist ein wichtiger Aspekt der Erfindung. Durch die gruppenweise Beobachtung lässt sich der Rechenaufwand und Speicherbedarf des Batteriemanagementsystems wesentlich verringern, wobei jedoch die Beobachtungsgüte im Vergleich zu einer Beobachtung aller Batteriezellen kaum gemindert wird, da alle Gruppen nacheinander beobachtet werden und die aus der Beobachtung abgeleiteten bzw. festgestellten Zustände auf alle Batteriezellen bezogen werden.

In weiterer bevorzugter Ausgestaltung des Verfahrens ist vorgesehen, dass die Beobachtung mittels eines Zellmodells realisiert wird, welches über wenigstens einen Parameter verfügt, aus dem sich wenigstens ein Zustand der Batteriezelle errechnen lässt.

Die Dauer der Beobachtung der Batteriezellen $t_B$ steht vorzugsweise zu einem für die Gesamtheit der Batteriezellen angesetzten Beobachtungszeitraum $t_{obs}$ in einem Verhältnis von $t_B/t_{obs}$ = $1/5*10^6$ ... $1/5*10^5$.

Vorteilhafterweise ist auch eine dem Zellenmodell zu Grunde liegende Zeitkonstante $\tau_{obs}$ wesentlich geringer als der Beobachtungszeitraum $t_{obs}$ . So kann zum Beispiel ein Beobachtungszeitraum $t_{obs}$ von 10 Jahren bzw. etwa 100.000 Fahrtkilometer für eine die Antriebsleistung eines Kraftfahrzeuges bereitstellende Batterie angenommen werden. Dies entspricht in etwa 2000 Betriebsstunden. Die Zeitkonstante $\tau_{obs}$ kann in diesem Fall weniger als 1 Stunde betragen, und die Dauer der Beobachtung der Batteriezellen $t_B$ kann in etwa 1 bis 10 Minuten, vorzugsweise 1 bis 5 Minuten betragen.

Die Kenntnis der prinzipiellen Funktionsweise der Gesamtheit der Batteriezellen und insbesondere der gleichmäßigen Beaufschlagung aller Batteriezellen mit bestimmten Einflüssen bzw. physikalischen Größen lässt eine Ausgestaltung des erfindungsgemäßen Verfahrens zu, bei der für wenigstens einen Parameter u analysiert wird, wie groß die Streuung $\sigma$ des Parameters $\upsilon_i$ der Gesamtheit der Batteriezellen $n_{ges}$ ist, wobei im Fall, dass die Streuung $\sigma$ einen vorher festgesetzten Grenzwert $\sigma_{max}$ nicht überschreitet, eine mittlere Änderung des Parameters $\Delta\upsilon_k$ für die Feststellung des jeweiligen Zustandes aller Batteriezellen der Gesamtheit der Batteriezellen $n_{ges}$ verwendet wird.

Diese Verwendung der mittleren Änderung des Parameters $\Delta\upsilon_k$ kann dabei durch seine unmittelbare Verrechnung erfolgen oder in einer Gewichtung mit einem definierten Faktor.

Somit kann eine Reduzierung der Beobachtungsqualität durch Ausnutzung der prinzipiellen Funktionsweise von Batteriepacks vermieden werden.

Es wird außerdem erfindungsgemäß ein Computerprogramm zur Verfügung gestellt, das es einer Datenverarbeitungseinrichtung ermöglicht, nachdem es in Speichermittel der Datenverarbeitungseinrichtung geladen worden ist, das erfindungsgemäße Verfahren zur Feststellung eines Ladezustandes und / oder eines Alterungszustandes einer Mehrzahl von räumlich zusammengefassten und schaltungstechnisch miteinander verbundenen Batteriezellen durchzuführen.

Ergänzt wird die vorliegende Erfindung durch ein computerlesbares Speichermedium, auf dem ein Programm gespeichert ist, das es einer Datenverarbeitungseinrichtung ermöglicht, nachdem es in Speichermittel der Datenverarbeitungseinrichtung geladen worden ist, das erfindungsgemäße Verfahren durchzuführen; sowie durch ein Verfahren, bei dem das Computerprogramm aus einem elektronischen Datennetz, wie beispielsweise aus dem Internet, auf eine an das Datennetz angeschlossene Datenverarbeitungseinrichtung heruntergeladen wird.

Des Weiteren wird erfindungsgemäß eine Batterie, insbesondere eine Lithium-Ionen-Batterie oder Nickel-Metallhydrid-Batterie, zur Verfügung gestellt, wobei die Batterie mehrere räumlich zusammengefasste und schaltungstechnisch miteinander verbundene Batteriezellen sowie wenigstens ein Batteriemanagementsystem umfasst und mit einem Antriebssystem eines Kraftfahrzeuges verbindbar oder verbunden ist, wobei das Batteriemanagementsystem derart ausgebildet ist, das erfindungsgemäße Verfahren zur Feststellung eines Ladezustandes und /oder eines Alterungszustandes einer Mehrzahl von räumlich zusammengefassten und schaltungstechnisch miteinander verbundenen Batteriezellen zu realisieren.

Außerdem wird erfindungsgemäß ein Kraftfahrzeug zur Verfügung gestellt, welches wenigstens eine erfindungsgemäße Batterie umfasst.

Mittels des erfindungsgemäßen Verfahrens lässt sich eine Reduktion von Rechenaufwand und Speicherbedarf von Batteriemanagementsystemen im Hinblick auf die Parameternachführung der beobachteten Zellen erzielen. Zudem kann die Skalierbarkeit von Batterieplattformsystemen und den damit verbundenen Batteriemanagementsystemen mit festgelegten, begrenzten Hardware-Ressourcen verbessert werden.

Neben den bereits genannten Vorteilen sind geringere Hardware-Kosten und/oder weniger von der Batteriezellenanzahl abhängige Hardware-Varianten notwendig. Es ist eine relativ hohe Beobachtungsqualität gewährleistet, da kein wesentlicher Informationsverlust bei der Beobachtung von Teilmengen von Batteriezellen, insbesondere nicht bei der alternierenden Beobachtung, zu verzeichnen ist. Die Beobachterstruktur lässt sich mittels Software und geeigneten Prozessoren realisieren und ist demzufolge kostengünstig.

Weitere vorteilhafte Ausführungsformen sind Teil der Patentansprüche.

Zeichnungen

Die Erfindung wird anhand der Zeichnungen und der nachfolgenden Beschreibung näher erläutert. Es zeigen:

Figur 1 eine mit einer herkömmlichen Beobachterstruktur versehene Batteriezelle, und

Figur 2 eine Einteilung der Batteriezellen und Beobachterstrukturen in Gruppen.

Die in Figur 1 dargestellte herkömmliche Beobachterstruktur wurde bereits in der Erläuterung des Standes der Technik beschrieben.

Ausführungsformen der Erfindung

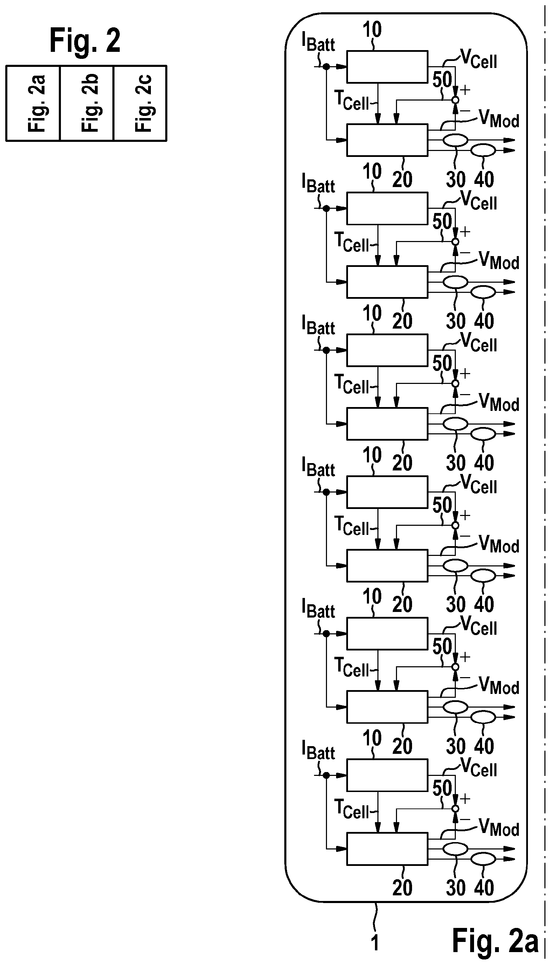

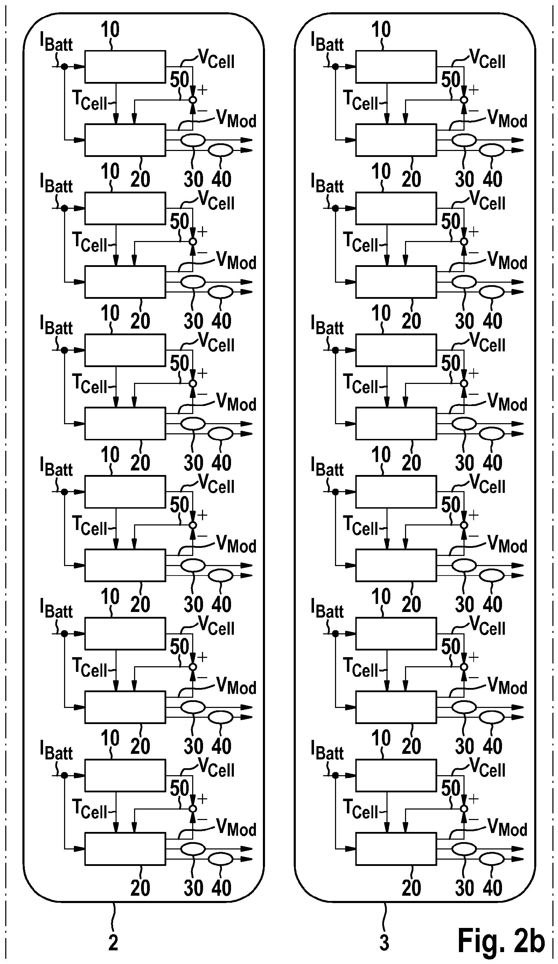

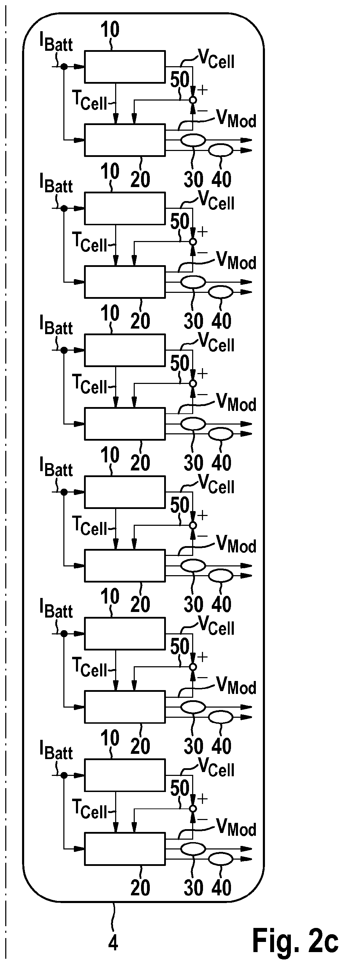

In Figur 2 ist die Gesamtheit aller hinsichtlich wenigstens eines ihrer Zustände zu erfassenden Batteriezellen dargestellt. Die Batteriezellen 10 sowie die ihnen zugeordneten Beobachterstrukturen 20 sind in vier Gruppen 1, 2, 3 und 4 eingeteilt.

Die Erfindung ist dabei jedoch nicht auf die Ausführung gemäß Figur 2 eingeschränkt, sondern es können abweichend davon auch lediglich mehrere Batteriezellen 10 ohne jeweils zugeordneter Beobachterstruktur in Gruppen zusammengefasst sein, wobei jeweils eine Gruppe von wenigstens einer übergeordneten Beobachterstruktur beobachtet wird. Die Rechnerleistung der Beobachterstruktur ist dementsprechend anzupassen.

Das erfindungsgemäße Verfahren wird vorzugsweise durch eine alternierende Beobachtung von jeweils nur einem Teil der verbauten Batteriezellen 10, nämlich der in jeweils einer Gruppe 1, 2, 3 oder 4 eingeordneten Batteriezellen 10, durchgeführt. Verfügt das Pack bzw. die Gesamtheit $n_{ges}$ aller Batteriezellen 10 über n Zellen, so kann vorteilhaft eine Untermenge m= n/x beobachtet werden, wobei n, x und m vorteilhafterweise ganzzahlig sind. Im Beispiel in Figur 2 sind n= 24 Zellen in x= 4 Gruppen zu je m= 6 Zellen dargestellt. Die Beobachtung der einzelnen Gruppen wechselt sich ab, die Zählreihenfolge kann beliebig gewählt werden. Besonders bietet sich die Abarbeitung in einer Schleife an.

Um die benötigten Hardware-Ressourcen zu fixieren und somit Kosten für die Umsetzung des Verfahrens planbar und gering zu halten, kann insbesondere die Anzahl der gleichzeitig beobachteten Zellen m bei Auslegung eines Batteriepacks stets gleich bzw. unter einem bestimmten Grenzwert gehalten werden. Somit skaliert mit der Zahl der Zellen n im Pack bzw. in der Gesamtheit $n_{ges}$ aller Batteriezellen 10 lediglich die Anzahl der Gruppen x.

Da die Zellenparameter, die beobachtet werden, alterungsabhängig sind, und da die Alterung von elektrochemischen Zellen für gewöhnlich relativ langsam erfolgt, sind die Beobachtungszeiträume $t_{obs}$ entsprechend lang. Solange sichergestellt ist, dass die Zeitkonstanten $\tau_{obs}$ der Beobachter wesentlich kleiner als die Beobachtungszeiträume $t_{obs}$ sind ($\tau_{obs} \ll t_{obs}$), kann das erfindungsgemäße Verfahren besonders vorteilhaft angewandt werden. Die Dauer der Beobachtung einer Gruppe bis zum nächsten Wechsel kann geeignet gewählt werden, sollte aber ebenfalls wesentlich geringer als die notwendigen Beobachtungszeiträume sein. So kann zum Beispiel ein Beobachtungszeitraum $t_{obs}$ von 10 Jahren bzw. etwa 100.000 Fahrtkilometer für eine die Antriebsleistung eines Kraftfahrzeuges bereitstellende Batterie angenommen werden. Dies entspricht in etwa 2000 Betriebsstunden. Die Zeitkonstante $\tau_{obs}$ kann in diesem Fall weniger als 1 Stunde betragen, und die Dauer der Beobachtung der Batteriezellen $t_B$ kann in etwa 1 bis 10 Minuten, vorzugsweise 1 bis 5 Minuten betragen.

Da alle Zellen in der betrachteten Gesamtheit der Batteriezellen $n_{ges}$ vorzugsweise in Reihe geschaltet sind, werden sie durch denselben Batteriestrom belastet. Dies gilt ebenfalls in erster Näherung bei Auslegung der Gesamtheit der Batteriezellen $n_{ges}$ mit mehreren parallelen Leitungssträngen. Somit ist der Ladungsdurchsatz identisch. Aufgrund der in der Regel guten thermischen Kopplung zwischen den Batteriezellen 10 und ihrem Betrieb in räumlicher Nähe ist die thermische Beanspruchung der einzelnen Batteriezellen 10 erwartungsgemäß ebenfalls ähnlich. Damit sind die beiden Hauptursachen für Alterung und damit Parameteränderung für die einzelnen Batteriezellen 10 nahezu identisch. Dieser Umstand kann dazu genutzt werden, die Beobachtungsqualität weiter zu erhöhen und eine annähernd lückenlose Beobachtung zu gewährleisten.

Dazu wird für einen Parameter u des Zellenmodells analysiert, wie groß die Streuung $\sigma$ der Parameter $\upsilon_i$ aller Batteriezellen 10 im Pack bzw. in der Gesamtheit aller Batteriezellen $n_{ges}$ ist. Unter der Voraussetzung, dass $\sigma$ einen zu definierenden Grenzwert nicht überschreitet - das heißt die Batteriezellen 10 der Gesamtheit aller Batteriezellen $n_{ges}$ ähnliches Verhalten aufweisen - kann die mittlere Änderung $\Delta\upsilon_k$, die in der beobachteten Gruppe festgestellt wird, ganz oder unter Gewichtung mit einem zu definierenden Faktor auf alle nicht beobachteten Batteriezellen 10 übertragen werden.

Dadurch kann in einem Batteriepack bzw. in der Gesamtheit aller Batteriezellen $n_{ges}$ unter gewissen - nicht unwahrscheinlichen - Bedingungen die Beobachtungsgüte der Zellparameter im Idealfall denselben Wert annehmen wie bei Beobachtung aller Zellen gleichzeitig, allerdings mit deutlich reduzierten Hardware-Aufwänden.

**Patentansprüche**

1. Verfahren zur Feststellung eines Ladezustands und/oder eines Alterungszustands einer Mehrzahl von räumlich zu einem Batteriepack zusammengefassten und schaltungstechnisch miteinander verbundenen Batteriezellen (10), wobei die Feststellung des Ladezustands und/oder des Alterungszustands durch Beobachtung von Batteriezellen (10) mittels wenigstens einer Beobachterstruktur (20) realisiert wird, wobei die Gesamtheit aller Batteriezellen ($n_{ges}$) in Gruppen unterteilt ist, wobei einer Gruppe jeweils eine Teilmenge ($n_x$) von Batteriezellen (10) zugeordnet ist, wobei die Teilmenge ($n_x$) der Gesamtheit von Batteriezellen ($n_{ges}$) beobachtet wird und die Beobachtung alternierend gruppenweise erfolgt und weiterhin der aus der Beobachtung abgeleitete Ladezustand und/oder Alterungszustand für mehr Batteriezellen (10) als für die beobachteten Batteriezellen (10) festgestellt wird, wobei für wenigstens einen Parameter (u) analysiert wird, wie groß die Streuung ($\sigma$) des Parameters ($\upsilon_i$) der Gesamtheit der Batteriezellen ($n_{ges}$) ist, wobei im Fall, dass die Streuung ($\sigma$) einen vorher festgesetzten Grenzwert ($\sigma_{max}$) nicht überschreitet, eine mittlere Änderung des Parameters ($\Delta\upsilon_k$) für die Feststellung des jeweiligen Ladezustands und/oder Alterungszustands aller Batteriezellen (10) der Gesamtheit der Batteriezellen ($n_{ges}$) verwendet wird.

2. Verfahren nach Anspruch 1, **dadurch gekennzeichnet, dass** die Feststellung des Ladezustands und/oder des Alterungszustands mittels Schätzung erfolgt.

3. Verfahren nach einem der vorhergehenden Ansprüche, **dadurch gekennzeichnet, dass** die Dauer der Beobachtung ($t_B$) der Batteriezellen zu einem für die Gesamtheit der Batteriezellen ($n_{ges}$) angesetzten Beobachtungszeitraum ($t_{obs}$) in einem Verhältnis von $t_B/t_{obs} = 1/(5*10^6) \dots 1/(5*10^5)$ steht.

4. Computerprogramm, das es einer Datenverarbeitungseinrichtung ermöglicht, nachdem es in Speichermittel der Datenverarbeitungseinrichtung geladen worden ist, ein Verfahren zur Feststellung wenigstens eines Ladezustands und/oder eines Alterungszustands einer Mehrzahl von räumlich zu einem Batteriepack zusammengefassten und schaltungstechnisch miteinander verbundenen Batteriezellen gemäß einem der Ansprüche 1 bis 3 durchzuführen.

5. Batterie, insbesondere Lithium-Ionen-Batterie oder Nickel-Metallhydrid-Batterie, die mehrere räumlich zu einem Batteriepack zusammengefasste und schaltungstechnisch miteinander verbundene Batteriezellen sowie wenigstens ein Batteriemanagementsystem umfasst und mit einem Antriebssystem eines Kraftfahrzeuges verbindbar ist, **dadurch gekennzeichnet, dass** das Batteriemanagementsystem mit dem Computerprogramm nach Anspruch 4 ausgebildet ist, das Verfahren gemäß wenigstens einem der Ansprüche 1 bis 3 zu realisieren.

6. Kraftfahrzeug, welches wenigstens eine Batterie gemäß Anspruch 5 umfasst, **dadurch gekennzeichnet, dass** die Batterie mit einem Antriebssystem des Kraftfahrzeuges verbunden ist.

**Claims**

1. Method for determining a state of charge and/or a state of health of a plurality of battery cells (10) spatially combined into a battery pack and connected to one another by circuitry, wherein the determination of the state of charge and/or state of health is implemented by observing battery cells (10) by means of at least one observer structure (20), wherein the totality of all the battery cells ($n_{tot}$) is divided into groups, wherein in each case one subset ($n_x$) of battery cells (10) is assigned to a group, wherein the subset ($n_x$) of a totality of battery cells ($n_{tot}$) is observed and the observation takes place groupwise in an alternating fashion and furthermore the state of charge and/or state of health derived from the observation is determined for more battery cells (10) than for the observed battery cells (10), wherein for at least one parameter (u) it is analyzed how large the variation ($\sigma$) of the parameters (ui) of the totality of the battery cells ($n_{tot}$) is, wherein, in the case of the variation ($\sigma$) not exceeding a previously defined limiting value ($\sigma_{max}$), an average change in the parameter ($\Delta\upsilon_k$) is used for the determination of the respective state of charge and/or state of health of all the battery cells (10) of the totality of the battery cells ($n_{tot}$).

2. Method according to Claim 1, **characterized in that** the state of charge and/or the state of health is determined by means of estimation.

3. Method according to one of the preceding claims, **characterized in that** the duration of the observation of the battery cells ($t_B$) has a relationship of $t_B/t_{obs} = 1/(5*10^6) \dots 1/(5*10^5)$ with an observation time period ($t_{obs}$) assumed for the totality of the battery cells ($n_{tot}$).

**4.** Computer program which, after it has been loaded into storage means of the data processing device, permits said data processing device to carry out a method for determining at least one state of charge and/or state of health of a plurality of battery cells spatially combined into a battery pack and connected to one another by circuitry according to one of Claims 1 to 3

**5.** Battery, in particular lithium-ion battery or nickel-metal-hydride battery, which comprises a plurality of battery cells spatially combined into a battery pack and connected to one another by circuitry as well as at least one battery management system, and which can be connected to a drive system of a motor vehicle, **characterized in that** the battery management system is designed to implement the method according to at least one of Claims 1 to 3 by the computer program according to Claim 4.

**6.** Motor vehicle which comprises at least one battery according to Claim 5, **characterized in that** the battery is connected to a drive system of the motor vehicle.

**Revendications**

**1.** Procédé permettant de constater un état de charge et/ou un état de vieillissement d'une pluralité d'éléments de batterie (10) regroupés physiquement en bloc-batterie et reliés entre eux par technologie de circuit, la constatation de l'état de charge et/ou de l'état de vieillissement étant réalisée en observant des éléments de batterie (10) au moyen d'au moins une structure d'observation (20), la totalité des éléments de batterie ($n_{ges}$) étant divisée en groupes, respectivement un sous-ensemble ($n_x$) d'éléments de batterie (10) étant associé à un groupe, dans lequel le sous-ensemble ($n_x$) de la totalité d'éléments de batterie ($n_{ges}$) est observé, et l'observation a lieu par groupes en alternance, et en outre, l'état de charge et/ou l'état de vieillissement déduit(s) de l'observation est/sont constaté(s) pour un plus grand nombre d'éléments de batterie (10) que pour les éléments de batterie (10) observés, dans lequel, pour au moins un paramètre (v), on analyse le degré de dispersion ($\sigma$) du paramètre ($\upsilon_i$) de la totalité des éléments de batterie ($n_{ges}$), dans lequel, au cas où la dispersion ($\sigma$) ne dépasserait pas une valeur limite ($\sigma_{max}$) fixée préalablement, une variation moyenne du paramètre ($\Delta\upsilon_k$) serait utilisée pour la constatation de l'état de charge et/ou de l'état de vieillissement respectif (s) de tous les éléments de batterie (10) de la totalité des éléments de batterie ($n_{ges}$).

**2.** Procédé selon la revendication 1, **caractérisé en ce que** la constatation de l'état de charge et/ou de l'état de vieillissement est effectuée au moyen d'une estimation.

**3.** Procédé selon l'une quelconque des revendications précédentes, **caractérisé en ce que** la durée de l'observation ($t_B$) des éléments de batterie présente avec une période d'observation ($t_{obs}$) spécifiée pour la totalité des éléments de batterie ($n_{ges}$) un rapport

$$t_B/t_{obs} = 1/(5*10^6) \ldots 1/(5*10^5).$$

**4.** Programme informatique qui permet à un dispositif de traitement de données, après avoir été chargé sur des moyens de mémoire du dispositif de traitement de données, d'exécuter un procédé permettant de constater au moins un état de charge et/ou un état de vieillissement d'une pluralités d'éléments de batterie physiquement regroupés en bloc-batterie et reliés entre eux par technologie de circuit selon l'une quelconque des revendications 1 à 3.

**5.** Batterie, en particulier batterie lithium-ion ou batterie au nickel-métal-hydrure, qui comprend plusieurs éléments de batterie physiquement regroupés en bloc-batterie et reliés entre eux par technologie de circuit ainsi qu'au moins un système de gestion de batterie, et peut être reliée à un système d'entraînement d'un véhicule automobile, **caractérisée en ce que** le système de gestion de batterie est réalisé avec le programme informatique selon la revendication 4 pour réaliser le procédé selon au moins l'une des revendications 1 à 3.

**6.** Véhicule automobile qui comprend au moins une batterie selon la revendication 5, **caractérisé en ce que** la batterie est reliée à un système d'entraînement du véhicule automobile.

Fig. 1

Fig. 2

| Fig. 2a | Fig. 2b | Fig. 2c |

Fig. 2a

Fig. 2b

Fig. 2c

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente

- DE 19959019 A1
- EP 2159585 A2

- US 20080233471 A1

### In der Beschreibung aufgeführte Nicht-Patentliteratur

- IEEE Standard for Rechargeable Batteries for Multi-Cell Mobile Computing Devices; IEEE Std 1625-2008 (Revision of IEEE Std 1625-2004. IEEE STANDARD. IEEE, 20. Oktober 2008, 1-79